Europäisches Patentamt

European Patent Office

Office européen des brevets

(19)

(11) Veröffentlichungsnummer: **0 168 643**
**B1**

(12) **EUROPÄISCHE PATENTSCHRIFT**

(45) Veröffentlichungstag der Patentschrift: 05.09.90

(21) Anmeldenummer: 85107360.1

(22) Anmeldetag: 14.06.85

(51) Int. Cl.⁵: **G 01 N 21/88,** G 02 B 21/00,
G 02 B 26/10,  G 01 N 21/64

(54) Gerät zur Wafer-Inspektion.

(30) Priorität: 14.06.84 DE 3422143

(43) Veröffentlichungstag der Anmeldung:
22.01.86 Patentblatt 86/04

(45) Bekanntmachung des Hinweises auf die
Patenterteilung:
05.09.90 Patentblatt 90/36

(84) Benannte Vertragsstaaten:
AT CH DE FR GB IT LI NL

(56) Entgegenhaltungen:
WO-A-79/01027
FR-A-2 339 167
GB-A-1 083 419
US-A-4 198 571

IBM TECHNICAL DISCLOSURE BULLETIN, Band
23, Nr. 12, Seiten 5422-5423, Mai 1981, D.
WAGNERS: "High resolution optical surface
microtopography"

(73) Patentinhaber: Heidelberg Instruments GmbH
Im Neuenheimer Feld 518
D-6900 Heidelberg 18 (DE)

(72) Erfinder: Bille, Josef, Prof. Dr.
Am Pferchelhang 2/4
D-6900 Heidelberg (DE)
Erfinder: Hunklinger, Siegfried, Prof. Dr.
Am Büchsenackerhang 68
D-6900 Heidelberg (DE)

(74) Vertreter: Lutz, Johannes Dieter, Dr.
Hohentwielstrasse 41
D-7000 Stuttgart 1 (DE)

EP 0 168 643 B1

**Beschreibung**

Die Erfindung betrifft ein Gerät zur Wafer-Inspektion mit den im Oberbegriff des Patentanspruchs 1 genannten, gattungsbestimmenden Merkmalen.

Ein Gerät dieser Art ist durch die wissenschaftliche Publikation von Karl L. Harris et al., Solid State Technology, Februar 1984, Seite 159 ff, bekannt. Mit Hilfe des bekannten Gerätes ist ein Wafer, d.h. eine zur Herstellung hochintegrierter Schaltkreise vorgesehene Halbleiterplatte, die typisch Abmessungen von etwa 15x15 cm (6"x6") haben kann, mittels einer Fernseh-Bilddarstellung vergrößert abbildbar; die Bildauswertung des Fernsehbildes erfolgt elektronisch mit einem Rechner mit hoher Verarbeitungsgeschwindigkeit. In einem hochauflösenden, nur bereichsweise durchgeführten Abtastbetrieb gelangen im wesentlichen nur Linienbreiten der sogenannten Die-Strukturen, d.h. einzelnen Funktionselementen des fertigen Halbleiterbauteils entsprechende Bereiche, wobei diese Bereiche in verschiedenen Stadien des Herstellungsprozesses, der Aufdampf-, Ätz-, Oxidations- und Lackbeschichtungsprozesse umfaßt, untersucht werden.

Erhebliche Nachteile des bekannten Geräts sind zumindest die folgenen:

Die zur Aufzeichnung des Fernsehbildes verwendete Vidikon-Röhre kann nur etwa 30 verschiedene Grau-Stufen unterscheiden, wodurch sich Begrenzungen hinsichtlich des Bildkontrastes, der Bildschärfe und damit letztlich auch des Auflösungsvermögens ergeben. Eine Fokussierung des abtastenden Elektronenstrahles ist jeweils nur auf eine bestimmte Untersuchungsebene des Wafers möglich, mit der Folge, daß das Fernsehbild auch aus diesem Grunde zwangsläufig erhebliche Unschärfen aufweist. Eine Veränderung der Ebene der scharfen Darstellung ist allenfalls dadurch möglich, daß das Wafer angehoben oder abgesenkt wird; die dafür erforderlichen mechanischen Einrichtungen arbeiten jedoch langsam und begrenzen zusätzlich der Verarbeitungsgeschwindigkeit Über die mittels der Vidikon-Abtastung erreichbare Bildinformation hinaus ist mit dem bekannten Gerät keine weitere Information gewinnbar.

Aufgabe der Erfingung ist es daher, ein Gerät zur Wafer-Inspektion anzugeben, das bei mindestens vergleichbarer Informationskapazität und -Verarbeitungsgeschwindigkeit präzisere und umfassendere Daten über die Struktur und den Gesamtzustand des Wafers im Verlauf der verschiedenen Prozeßschritte der Herstellung zu liefern vermag.

Diese Aufgabe wird durch die Merkmale des Patentspruchs 1 gelöst.

Hieraus resultiernde Vorteile des erfindungsgemäßen Gerätes sind zumindest die folgenden:

Durch die optische Abtastung der Wafer-Oberfläche werden Aufladungen einzelner Bereiche des Wafers vermieden, die zu einer Veränderung der elektrischen Eigenschaften des fertigen Bauteiles führen könnten. Das erfindungsgemäße Gerät erlaubt eine wesentlich schnellere Abtastung des Untersuchungsbereiches, wobei mit Hilfe eines elektronisch ansteuerbaren aktiven Spiegels die Untersuchungsebenen praktisch trägheitslos geändert werden können und eine Vielzahl von schichtweisen Abtastungen des Untersuchungsobjektes möglich sind, die zu einer präzisen, kontrastreichen und hochauflösenden Bildauflösung verarbeitet werden können.

Die Verwendung eines Laser-Abtast-Mikroskops zur Fokussierung des Laser-Abtastlichtbündel erlaubt eine enge Begrenzung der Tiefe (Schärfentiefe) des Untersuchungsbereiches und damit eine hochauflösende Unterteilung desselben in einzeln darstellbare Schichten, wobei die Auswertung der gewinnbaren Bilddaten eine genaue topographische Darstellung der Wafer-Oberfläche erlaubt. Durch die mittels der konfokalen Anordnung einer Lochblende mit der Brennebene des Mikroskop — Objektivs erzielte Eingrenzung des Nachweislichtes auf den Schärfentiefenbereich wird ein hohes Signal-/Rausch-Verhältnis erzielt, das ein Abtasten des Untersuchungsbereiches mit hoher Abtastfrequenz erlaubt.

Die Verwendung eines aktiven Spiegels zur Fokusversetzung des Abtastlichtes vermittelt den Vorteil, daß auf Vorrichtungen zum Anheben und Absenken des Wafers zur Einstellung bestimmter Abtastebenen verzichtet werden kann.

Durch die Merkmale des Anspruchs 2 ist eine günstige Anordnung desselben innerhalb des Abtast-Strahlenganges angegeben.

Durch die gemäß Anspruch 3 vorgesehene Möglich k eit einer Speicherung der für eine Vielzahl in kleinen Schrittweiten von z.B. 0,1 µm gestaffelter Untersuchungsebenen ermittelter Bild-Daten bietet die Möglichkeit, durch eine rechnergesteuerte Ordnung dieser Bild-Daten Schnitt-Profildarstellungen des Untersuchungsobjektes in beliebigen Ebenen zu erzeugen.

Um mindestens bereichsweise den Bildkontrast erhöhen zu können, ist es vorteilhaft, wenn, wie gemäß Anspruch 4 vorgesehen, die Intensität des Abtast-Lichtstromes gezielt erhöht werden kann.

Durch die Merkmale des Anspruchs 5, die in spezieller Gestaltung gemäß Anspruch 6 realisiert sein können, wird hinreichend zuverlässig vermieden, daß durch zufällige Interferenzen ein Auslöschen des Nutzsignals auftreten kann.

Die durch die Merkmale des Anspruchs 7 ihrem grundsätzlichen Aufbau nach umrissene und durch die Merkmale der Ansprüche 8-11 näher spezifizierte, bevorzugte Ausführungsform des erfindungsgemäßen Gerätes vermittelt den Vorteil, daß aus einer Auswertung der mittels einer zweiten Abtast-Einrichtung erfaßten Punktbild-Funktionen nacheinander abgetasteter Bildelemente eine Autofokussierung des Abtaststrahles der zur Bildabtastung vorgesehenen Abtasteinrichtung möglich ist, wodurch sich scharfe Profildarstellungen der Wafer-Oberfläche erzeugen lassen und auch genaue Informationen hinsichtlich der Schichtdikken von Oxydschichten gewinnen lassen.

Solche Informationen können auch in der durch die Merkmale des Anspruchs 12 und des Anspruchs 13 angegebenen Gestaltung des erfindugsgemäßen Geräts gewonnen werden.

Mittels einer gemäß Anspruch 14 vorgesehenen, in spezieller Gestaltung durch diejenigen des Anspruchs 15 realisierbaren Lumineszenz — Meßeinrichtung können insbesondere Fotolackreste auf der Wafer-Oberfläche zuverlässig erkannt werden.

Wenn eine gemäß Anspruch 16 gestaltete Transportvorrichtung für das Wafer vorgesehen ist, kann im Rahmen der Abtasteinrichtung auf einen zur Y-Strahlablenkung erforderlichen Galvanometerspiegel verzichtet werden.

Ein Vergleich eines zeilenförmigen Abtastbereiches mit einer vorgegebenen Soll-Struktur kann auch mit hilfe eines sogenannten Konvolvers erfolgen, der eine nicht lineare Superposition sich in entgegengesetzter Richtung in einem piezoelektrischen Material ausbreitender Oberflächenwellen vermittelt, denen ein der Soll-Struktur und andererseits dem für die reale Struktur gemessenen Intensitätsverlauf des Abtastlichtes entsprechender Amplitudenverlauf aufgeprägt ist, sodaß aus einer Messung des Integrales der Korrelationsfunktion dieser Oberflächenwellen eine Aussage über die Übereinstimmung der genannten Strukturen gewinnbar ist.

Weitere Einzelheiten der Erfindung ergeben sich aus der nachfolgenden Beschreibung spezieller Ausführungsbeispiele anhand der Zeichnung. Es zeigen:

Fig. 1 den Strahlengang einer bevorzugten Ausführungsform des erfindungsgemäßen Geräts,

Fig. 2 eine schematische Darstellung der Rechenoperationen zur Auswertung von Bildpunktfunktionen und der hieraus gewinnbaren Stellsignale für einen im Rahmen des erfindungsgemäßen Gerätes zur Einstellung der Untersuchungsebenen vorgesehenen aktiven Spiegel und

Fig. 3 eine spezielle Art der Abtastung des Untersuchungsfeldes eines Wafers.

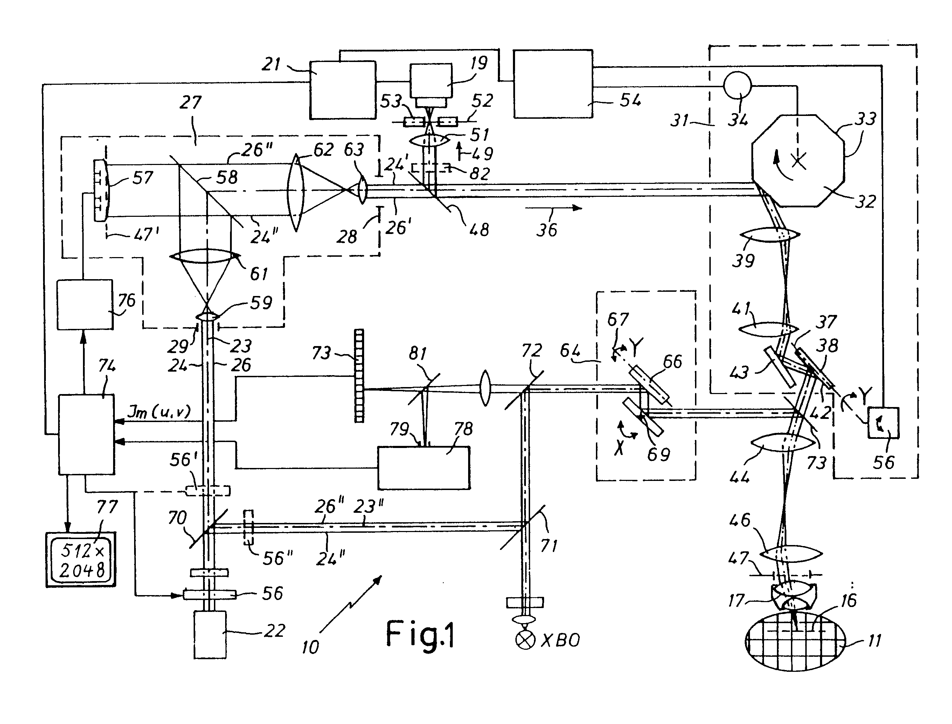

Das in der Fig. 1, auf deren Einzelheiten ausdrücklich verwiesen sei, dargestellte, erfindungsgemäße Gerät 10 ist für eine sogenannte Wafer-Inspektion gedacht, d.h. für die Fertigungskontrolle bei der Herstellung von hochintegrierte Halbleiter-Bauelementen, die in einer Vielzahl von Prozeßschritten hergestellt werden. Hierbei werden auf ein sogenanntes Wafer 11 — eine Silizium Platte mit einem Durchmesser von bis zu 6 Zoll in Aufdampf-, Ätz- und Oxidations sowie Diffusions und Dotierungsprozessen Strukturen erzeugt, die einer äußerst komplexen Anordnung elektronischer Schaltungselemente entsprechen. Mit Hilfe des Gerätes 10 sollen die für bestimmte Stadien des Herstellungsprozesses charakteristischen Strukturen möglichst schnell mit Soll-Strukturen vergleichbar sein, um Herstellungsfehler zuverlässig erkennen und ein mit solchen Fehlern behaftetes Wafer rechtzeitig aus dem Produktionsprozeß ausscheiden zu können.

Anhand der nachfolgend beschriebenen konstruktiven und funktionellen Details des Geräts 10 werden auch Verfahrensweisen zu dessen zweckgerechter Benutzung erläutert werden, die ebenfalls als zum Gegenstand der Erfindung gehörig angesehen werden sollen.

Das Gerät 10 ist seinem grundsätzlichen Aufbau nach ein sogenanntes Laser-Abtast-Mikroskop (Laser-Scanning-Mikroskop), das mit zeilenweiser und innerhalb jeder Zeile punktweiser Abtastung des Untersuchungsobjektes oder -bereiches und einer in prinzipieller Analogie zur Darstellung eines Fernsehbildes erfolgenden Darstellung des Untersuchungsbereiches 16 arbeitet, der in der Fig. 1 durch die Fokussierungsebene eines Mikroskop-objektivs 17 schematisch angedeutet ist, die speziell die Oberfläche einer nach einem bestimmten Prozeßschritt erzeugten Wafer-Struktur sei.

Dabei werden die einzelnen — im wesentlichen punktformigen Elementarbereiche des Untersuchungsbereiches 16 sequentiell in dem genannten Zeilen- bzw. Punktraster mit Laserlicht beleuchtet, und es wird für jeden Elementarbereich die Intensität des von diesem ausgehenden Reflexions- bzw. Streulichtes gemessen, die mittels eines photoelektrischen Detektors, speziell eines Photomultipliers 19 für jedes Bildelement gesondert erfaßt wird. Die solchermaßen erfaßten Intensitätswerte des vom Untersuchungsobjekt zurückgeworfenen Laserlichtes werden synchron zur Lichtabtastung des Untersuchungsobjektes in einen Bildspeicher 21 eingegeben und dort für die weitere Verarbeitung — Bilddarstellung und ggf. rechnerische Verarbeitung der Intensitätsdaten — bereitgehalten.

Als Lichtquelle 22 des Geräts 10 ist ein He-Cd-Laser vorgesehen, der bei den Wellenlängen $\lambda 1 = 325\,nm$ und $\lambda 2 = 440\,nm$, d.h. im nahen UV-Bereich sowie im violetten Bereich des sichtbaren Spektrums Licht emittiert. Dieser Laser 13 ist ein sog. cw-Laser, der kontinuierlich abstrahlt. Der Primärstrahl dieses Helium-Cadmium-Lasers 22 ist in der Fig. 1 durch seinen strich-punktiert eingezeichneten Zentralstrahl 23 und seine Randstrahlen 24 und 26 repräsentiert. Der Primärstrahl 23, 24, 26 des He-Cd-Lasers 22 ist im wesentlichen ein Parallelbündel mit einem Bündelquerschnitt von ca, 1 mm².

Mittels einer insgesamt mit 27 bezeichneten Strahl-Formungsoptik ist eine für die weitere Ausnutzung des Laserlichtes geeignete Bündelform im Sinne einer Anpassung des Bündelquerschnitts an die zur weiteren optischen Verarbeitung vorhandenen optischen Einrichtungen sowie im Sinne einer im folgenden noch näher zu erläuternden Beeinflussung der Konvergenz des Laserlichtbündels einstellbar. Die Randstrahlen des Ausgangslichtbündels der Strahl-Formungsoptik 27, das an deren Ausgang 28 einen größeren Querschnitt hat als an deren Eingang 29, sind mit 24' und 26' bezeichnet.

Das Ausgangslichtbündel 23, 24', 26' der Strahl-Formungsoptik 27 wird einer insgesamt mit 31 bezeichneten Abtast-(Scan)-Einrichtung zugeleitet, die einerseits eine "horizontale" und andererseits eine "vertikale" Strahlablenkung vermittelt, die in dem genannten Abtast-Raster die Abtastung des Untersuchungsbereiches 16 in den X- und Y-Koordinatenrichtungen ermöglicht.

Als Horizontal-Ablenkungs-Element ist ein sog. Polygonspiegel 32 vorgesehen, dessen Facetten 33 in der Darstellung der Fig. 1 ein regelmäßiges Achteck begrenzen. In einer typischen Realisierungsform hat der Polygonspiegel 32 jedoch 24 Facetten 33 in regelmäßigpolygonaler Anordnung zueinander.

Der Polygonspiegel 32 ist mittels eines Elektromotors 34 rotierend antreibbar, wobei die Rotationsfrequenz dieses Polygonspiegels 32 in einer im folgenden noch näher erläuterten Weise mit der Abspeicherung der Ausgangssignale des Photomultipliers 19 in den Bildspeicher 21 synchronisiert ist, in welchem in digitalem Format das Bild des Untersuchungsbereiches 16 abgespeichert wird.

Die Y-Auslenkung des Laser-Lichtbündels 23, 24', 26' ist, in der durch den Pfeil 36 wiedergegebenen Ausbreitungsrichtung des Laser-Lichtbündels 23, 24', 26' gesehen, der X-Auslenkung 32, 34, nachgeordnet, und wird mittels eines um eine horizontale Achse 37 schwenkbar angetriebenen Galvanometerspiegels 38 in für sich bekannter Weise erzielt.

Die Facettenflächen 33 des Polygonspiegels 32 werden in einem sogenannten telezentrischen Strahlengang, der mittels zweier Linsen 39 und 41 realisiert ist, auf die reflektierende Fläche 42 des Galvanometerspiegels 38 abgebildet. Ein zwischen der Austrittslinse 41 dieses telezentrischen Strahlenganges und dem Galvanometerspiegel 38 angeordneter Umlenkspiegel 43 ist lediglich zur Erzielung einer günstigen Strahlengang-Geometrie vorgesehen.

Mittels einer zu der telezentrischen Linsenanordnung 39, 41 analogen telezentrischen Linsenanordnung 44, 46, wird die reflektierende Fläche 42 des Galvanometerspiegels 38 auf die Eintrittspupille 47 des Mikroskopobjektivs 17 abgebildet, das seinerseits das als Parallelbündel oder nahezu paralleles Lichtbündel durch die Eintrittspupille 47 hindurchtretende Laserlicht in die Untersuchungsebene 16 fokussiert.

Das an den in der Fokussierungs bzw. der Untersuchungsebene 16 vorhandenen Strukturen des Untersuchungsobjektes reflektierte bzw. gestreute Laserlicht wird in den insoweit erläuterten Strahlengang zurückgeworfen und mittels eines teildurchlässigen Spiegels 48, in der Regel eines halbdurchlässigen Spiegels, der zwischen dem Polygonspiegel 32 und dem Ausgang 28 der Strahl-Formungsoptik 27 angeordnet ist, in Richtung des Pfeils 49 aus dem Abtast-Strahlengang ausgekoppelt. Dieses ausgekoppelte Lichtbündel 23', 24', 26' wird mittels eines weiteren Mikroskopobjektivs 51 fokussiert; in der Brennebene 52 dieses weiteren Mikroskopobjektivs 51 ist eine Lochblende 53 angeordnet, die eine Bündelbegrenzung dahingehend vermittelt, daß durch diese Lochblende 53 nur solches Laserlicht als für die Intensitätsmessung ausgenutztes Nutzlicht hindurchtreten kann, das aus dem dem Schärfentiefenbereich des Mikroskopobjektivs 17 entsprechenden Bereich der die Untersuchungsebene 16 bildenden Brennebene des Mikroskopobjektivs 17 stammt. In der Ausbreitungsrichtung 49 des aus dem Beleuchtungsstrahlengang ausgekoppelten Laserlichtes gesehen, ist hinter der Lochblende 53 der Photomultiplier 19 angeordnet, der ein zur Intensität des vom Untersuchungsobjekt in den Abtaststrahlengang zurückgeworfenen Laserlichtes proportionales Ausgangssignal erzeugt.

Die je einem Elementarbereich der Untersuchungsebene 16 zugeordneten Ausgangssignale des Photomultipliers 19 werden, gesteuert durch eine Synchronisiereinrichtung 54, die die zweckgerechte Steuerung der Rotation des Polygonspiegels 32 sowie der Schwenkbewegungen des Galvanometerspiegels 38 vermittelt, letztere durch einen Schwenkantrieb 56, in dem Bildspeicher 21 gespeichert.

Zur Erzeugung eines mittels eines Fernsehbildschirmes darstellbaren Bildes des Untersuchungsbereiches 16 wird das Untersuchungsfeld in 512 x 2 048 Bildpunkte zerlegt, analog zur Erzeugung eines üblichen Fernsehbildes. Es werden demgemäß 512 Bildzeilen abgetastet und innerhalb jeder Zeile 2 048 Bildpunkte. Die Größe, d.h. die Ausdehnung der Bildpunkte in "horizontaler" und "vertikaler" Richtung ergibt sich aus der Größe des Bildfeldes, dividiert durch die Anzahl der Bildpunkte pro Zeile bzw. Bildhöhe dividiert durch die Zeilenzahl. Je nach der Brennweite des Mikroskopobjektivs 17 variiert die Größe des Bildfeldes zwischen 100 μm und mehreren mm; entsprechend variiert die Bildpunktgröße zwischen 0,05 μm und einigen μm.

Die Abtastung des Untersuchungsbereiches 16 erfolgt so rasch, daß das Bildfeld in 40 ms abgetastet wird, wobei in jeweils 20 ms ein Halbbild abgetastet wird, deren eines die ungeraden und der anderes die geraden Zeilenzahlen enthält. Diese beiden Halbbilder werden dann in für sich bekannter Weise einander überlagert.

Die Synchronisierung des Einlesens der Photomultiplier-Ausgangssignale in den Bildspeicher 21 mit den Abtast-Bewegungen des Polygonspiegels 32 und des Galvanometerspiegels 38 erfolgt in bekannter Weise, wie in der wissenschaftlichen Publikation von Scheck (R. Scheck, R. Baker, R. Buchroeder, D. Hillman, R. Shoemaker, and P. H. Bartels, Journal of Histochemistry and Cytochemistry 27, 153 (1979)), beschrieben.

Mit dem Einlesetakt synchronisiert ist auch ein elektrooptischer oder akustooptischer Modulator, mittels dessen die Intensität des in die Untersuchungsebene 16 geworfenen Laserlichts moduliert werden kann. Hierdurch ist es möglich, Bereiche des Untersuchungsfeldes mit höherer Intensität zu beleuchten als den übrigen Teil des Untersuchungsfeldes. Dies ist insbesondere dann von Bedeutung, wenn einzelne Bereiche mit hohem Kontrast abgebildet werden sollen.

Um in rascher zeitlicher Folge eine Mehrzahl von Untersuchungsebenen 16, 16' und 16'' abtasten zu können, ist ein sog. aktiver Spiegel 57 vorgesehen, dem durch elektrische Ansteuerung eine — positive oder negative — Brechkraft aufprägbar ist, die eine Veränderung der Position der Untersuchungsebene 16, senkrecht zu dieser gesehen, innerhalb eines Bereichs von ± 10 µm, bezogen auf eine vorab gewählte Lage der Untersuchungsebene 16, ermöglicht.

Es sei angenommen, daß dieser aktive Spiegel 57 im nichtangesteuerten Zustand wie ein ebener Spiegel wirkt.

Der aktive Spiegel 57 ist in einer zur Ebene der Eintrittspupille 47 des Mikroskopobjektivs 17 entsprechenden Pupillenebene 47' angeordnet. Er wird über einen teildurchlässigen — halbdurchlässigen — Spiegel 58 der Strahl-Formungsoptik 27 ausgeleuchtet, an dem der mittels einer telezentrischen Linsenanordnung 59, 61, die die beiden Sammellinsen 59 und 61 verschiedener Brennweiten umfaßt, aufgeweitete Ausgangslichtstrahl 23, 24, 26 des Lasers 22 zum aktiven Spiegel 57 hin umgelenkt wird. Der vom aktiven Spiegel 57 zurückgeworfene, durch die Randstrahlen 26'' und 24'' repräsentierte, durch den teildurchlässigen Spiegel 58 hindurchtretende Lichtstrom wird mittels einer weiteren telezentrischen Anordnung von Linsen 62 und 63 der Strahl-Formungsoptik 27 auf den für die weitere, bereits erläutere Ausnutzung des Laser-Lichtstromes geeigneten Querschnitt gebracht, mit dem das Laser-Lichtbündel 23, 24', 26', am Ausgang 28 der Strahl-Formungsoptik 27 austritt.

Das insoweit erläuterte Gerät 10 kann somit durch zweckgerechte Ansteuerung des aktiven Spiegels 57, ggf. programmgesteuert, schnell und präzise auf die Abtastung verschiedener, z.B. äquidistant gestaffelter Untersuchungsebenen 16, 16' und 16'' eingestellt werden, deren Bilder, eine hinreichende Kapazität des Bildspeichers 21 vorausgesetzt, in ihrer Gesamtheit gespeichert werden können. Der Inhalt des Bildspeichers 21 kann dann zur Darstellung beliebiger Schnittebenen durch den insgesamt erfaßten Untersuchungsbereich ausgenutzt werden, die schräg zu den abgetasteten Untersuchungsebenen oder auch senkrecht zu diesen verlaufen können.

Bedingt durch die erläuterte Art der Abtastung der Untersuchungsbereiche 16, 16' und 16'' sind die erzielbaren Abbildungen dieser Untersuchungsbereiche zwangsläufig mit Unschärfen behaftet, die dadurch zustandekommen, daß Bereiche, die vor und hinter der Ebene mit optimaler Bildschärfe liegen, zur Intensitätsverteilung des für den Nachweis ausgenutzten Laserlichtes beitragen. Diese Einflüsse können jedoch durch sukzessive Schichtaufnahmen und deren dadurch erfaßbare Veränderungen auch rechnerisch berücksichtigt und kompensiert werden, so daß aus einer rechnerischen Nachverarbeitung des Speicherinhalts scharfe und kontrastreich Darstellungen der untersuchten Strukturen erzielt werden können.

Dies geschieht zweckmäßigerweise unter Ausnutzung der als — bekannt voraussetzbaren — dreidimensionalen Übertragungsfunktion des Mikroskopobjektivs 17. Die erwähnte rechnerische Korrektur der Bildschärfe anhand einer Serie von Schichtaufnahmen für verschiedene Untersuchungsebenen schließt auch die Möglichkeit ein, ein scharfes räumliches Bild des Untersuchungsobjektes mit gleichsam unendlicher Schärfentiefe erzeugen zu können, da die erwähnte rechnerische Korrektur natürlich für jede Schichtebene erfolgen kann.

Es können eine Vielzahl von Schnittprofilen der auf das Wafer aufgebrachten Strukturen — geätzte Photo-Lack-Strukturen, leitende Metall-Strukturen und isolierende $SiO_2$-Streifen — erfaßt und dargestellt werden Charakteristisches Merkmal des Geräts 10 gemäß Fig. 1 ist, wie schon erwähnt, die konfokale Anordnung der Lochblende 53 zu der die Untersuchungsebene markierenden Brennebene 16 des Mikroskopobjektivs 17, woraus resultiert, daß nur solches Licht durch die Lochblende hindurchtreten kann, das aus dem Schärfentiefenbereich eines durch das Mikroskopobjektiv 53 entwerfbaren Bildes hindurchtreten kann. Die aus anderen Bereichen, die — in Ausbreitungsrichtung des Laser-Lichtes gesehen — vor oder hinter der Brennebene 16 des Mikroskopobjektivs liegen, reflektierten bzw. getreuten Lichtströme werden durch den konfokalen Strahlengang auf den Rand der Lochblende 53 geworfen und somit gegen den Photomultiplier 19 abgeschattet.

Dies ist insbesondere von Bedeutung dafür, daß die dem Schärfentiefenbereich des Mikroskopobjektivs 17 entsprechende Dicke des Untersuchungsbereiches 16 gering ist. Sie beträgt in typischen Fällen zwischen 0,05µm und 1µm.

In typischer Auslegung des Gerätes 10 hat das Mikroskopobjektiv 17 eine Brennweite von 5 mm und eine numerische Apertur von 0,9. Der Durchmesser des Laser-Lichtbündels 23, 24', 26', das durch das Mikroskopobjektiv 17 in die Untersuchungsebene 16 fokussiert wird, beträgt bis zu 6 mm.

Je nach Wahl des Mikroskopobjektives 17 und des genannten Bündelquerschnittes kann ein Auflösungsvermögen von weniger als 0,2µm erreicht werden.

Zusätzlich zu der Abtast-Einrichtung 31 ist eine weitere, insgesamt mit 64 bezeichnete Abtast-Einrichtung vorgesehen, die in prinzipiell derselben Weise, wie vorstehend anhand der Abtasteinrichtung 31 erläutert, eine teilweise oder vollständige Abtastung des Untersuchungsbildfeldes ermöglicht. Diese Abtasteinrichtung 64 umfaßt als Abtastelemente einen ersten Galvanometerspiegel 66, der um eine horizontale, d.h. zur Ausgreitungsebene des Abtast-Lichtes parallele Achse 67 schwenkbar ist und die Y-Auslenkung des Abtast-Lichtes vermittelt, sowie einen zweiten Galvanometerspiegel 68, der um eine senkrecht zur Ausbreitungsebene des Abtast-Lichtes verlaufende Achse 69 schwenkbar ist und demgemäß die X-Auslenkung, d.h. die Zeilen Auslenkung vermittelt.

Als Abtastlicht wird ein vom Ausgangslichtstrom 23, 24, 26, des He-Cd-Lasers 22 abgezweigter Teillichtstrom 23'', 24'', 26'', ausgenutzt. Dieser Teillichtstrom 23'', 24'', 26'' wird in der aus der Fig. 1 ersichtlichen Geometrie über einen ersten. teildurchlässigen Umlenkspiegel 71 und einen zweiten teildurchlässigen Umlenkspiegel 72 sowie über die weitere Abtast-Einrichtung 64 und einen weiteren teildurchlässigen Spiegel 73 in den für die Abbildung des Untersuchungsbereiches 16 vorgesehenen Strahlengang eingekoppelt, wobei diese Einkopplung des weiteren Abtast-Lichtstromes zwischen dem Galvanometerspiegel 38 der ersten Abtast-Einrichtung 31 und der einen Linse 44 der telezentrischen Linsenanordnung 44, 46, erfolgt, die vor der Eintrittspupille 47 des Mikroskopobjektivs 17 angeordnet ist.

Die Intensität des für die zusätzliche Abtastung ausgenutzten Teillichtstromes 23'', 24'', 26'' beträgt nur etwa 10% der Intensität des Ausgangslichtstromes des He-Cd-Lasers.

Zur Intensitätskontrolle der Abtastlichtströme sind in diesem Falle 2 Modulatoren 56' und 56'' in der aus der Fig. 1 ersichtlichen Anordnung bezüglich eines teildurchlässigen Spiegels 70 vorgesehen.

Die weitere Abtasteinrichtung 64 wird asynchron zur Abtasteinrichtung 31 und mit wesentlich geringerer Abtastfrequenz betrieben. Das vom Untersuchungsobjekt durch Reflexion bzw. Streuung in den Strahlengang der weiteren Abtasteinrichtung 66 zurückgeworfene Licht wird mit einer zweidimensionalen (2 D) Matrixanordnung photoelektrischer Empfänger, vorzugsweise einer Dioden-Matrix 73, hinsichtlich seiner zweidimensional-räumlichen Intensitätsverteilung erfaßt, wobei die Intensitätsverteilung der jeweils von einem beleuchteten Bildelement zurückgeworfenen Strahlung gemessen und für eine weitere Verarbeitung gespeichert wird, d.h. es wird die sog. Punktbildfunktion (Point Spread Function — PS-Funktion) aufgezeichnet. Aus der solchermaßen erfaßten PS-Funktion kann unter Anwendung bekannter Algorithmen, deren Grundzüge im folgenden zum besseren Verständnis noch kurz erläutert werden, eine Abweichung des Verlaufs der Wellenfront des durch Teile des Untersuchungsobjekts hindurchtretenden Abtast-Lichtes von dem nach den geometrischoptischen Randbedingungen zu erwartenden Idealverlauf errechnet werden. Besonders interessant ist die Ermittlung der PS-Funktion deshalb, weil aus der räumlichen Intensitätsverteilung des Punktbildes auf Strukturen geschlossen werden kann, deren charakteristische Dimensionen kleiner sind als diejenigen des als Abtastpunkt beleuchteten Bildelementes. Es können auf diese Weise Kantenstrukturen genau erfaßt werder, sowie kleinste Schmutzpartikel erkannnt werden.

Bei dem erfindungsgemäßen gerät 10 wird die mittels der weiteren Abtast-Einrichtung 64 gemessene punktbildfunktion auch zu einer punktweisen Autofokussierung des Abtast-Lichtbündels auf die auf das Wafer 11 aufgerachte Struktur ausgenutzt. Hierzu wird von einem Rechner 74 ein Vergleich der gemessenen Intensitätsverteilung mit einer für genaue Fokussierung des Abtast-Lichtbündels auf die abgetastete Fläche charakteristischen idealen Punktbild-Funktion durchgeführt. Aus diesem Vergleich werden Stellsignale für eine kompensatorische Ansteuerung des aktiven Spiegels 57 erzeugt, derart, daß die mittels der weiteren Abtasteinrichtung 64 gemessene Intensitätsverteilung in guter Näherung auf die ideale Punktbildfunktion "eingeregelt" wird.

Die dadür erforderlichen Stellsignale können nach Betrag und Änderungssinn in Einheiten eines Abstandes von einer Referenzebene ausgewertet werden. Dadurch können im Ergebnis die Schichtdicken oder Höhen von Oberflächen-profilierungen fortlaufend erfaßt werden.

Die Oberflächen-Struktur des Wafers 11 ist somit in sämtlichen Koordinatenrichtungen (X- und Y-Richtung durch die Abtastung, die Z-Richtung durch die Auswertung der Punktbildfunktion) darstellbar.

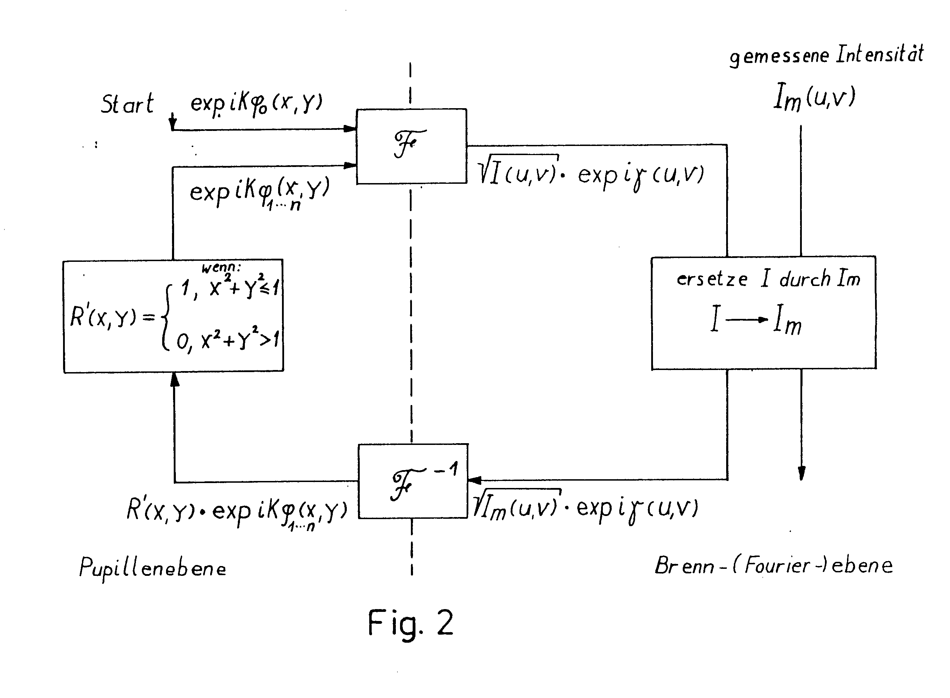

Zu einer vereinfachten Erläuterung des Rechenverfahrens, nach welchem der Rechner 74 die mittels der weitern Abtasteinrichtung 64 gewonnenen PS-Funktionsdater verarbeitet, sei nunmehr auf die Fig. 2 verwiesen, in der diese Rechenverfahren schematisch dargestellt ist:

Dieses Verfahren besteht in der Durchführung einer Iteration, wonach unter Berücksichtigung der mit der Diodenmatrix 73 erfaßten Intensitätsverteilung (der Punktbild- bzw. der PS-Funktion) $I_m$ (u,v) (u = Zeilenindes, v = Spaltenindex der Diodenmatrix) ein Verlauf der Wellenfront des Abtastlichtes am Ort der Eintrittspupille 47 des Mikroskopobjektivs 17 errechnet wird, der mit der gemessenen Intensitätsverteilung $I_m$ (u,v) konsistent ist.

Ausgegangen wird dabei von der plausiblen Annahme, daß das Lichtfeld am Ort (x,y) der Eintrittspupille 47 des Mikroskopobjektivs 17 eine durch einen Phasenfaktor $\varphi_o$ (x,y) charakterisierbare ebene Wellenfront habe. Unter Berücksichtigung der Übertragungsfunktion des optischen Systems durch Faltung der Wellenfront R (x, y) expik $\varphi_o$ mit der Übertragungsfunktion F dieses Systems — wird der Verlauf des Lichtfeldes $\sqrt{I(u,v)}$ expi $\zeta$ (u,v) in der Brennebene — der Untersuchungsebene 16 — des Mikroskopobjektivs 17 berechnet. Durch Ersatz der Amplitudenfaktoren $\sqrt{I(u,v)}$, durch die aus den Messungen gewinnbaren Werte $\sqrt{Im(u,v)}$, und Anwendung der inversen Übertragungsfunktion $F^{-1}$ auf diesen für die Brennebene angesetzen Lichtfeldverlauf wird nunmehr ein mit diesem Feldverlauf konsistenter Verlauf der Wellenfront an der Eintrittspupille 47 des Mikroskopobjektivs 17, d.h. ein damit konsistenter Phasenfaktor $\varphi_1$ (x,y) errechnet. Im ersten Iterationsschritt wird nun dieser Phasenfaktor für die Beschreibung des Lichtfeldes am Ort der Eintrittspupille angesetzt und wieder, wie zuvor beschrieben, das Wellenfeld in der Brennebene des Mikroskopobjektivs 17 errechnet; des weiteren werden die Amplitudenfaktoren durch die Wurzeln der gemessenen Intensitätswerte ersetzt und der neue Phasenfaktor $\varphi_2$ (x,y) berechnet. Derartige Iterationsschritte werden so lange wiederholt, bis die gemessenen Intensitäten $I_m$ (u,v) innerhalb vorgebbarer Schranken mit den errechneten Intensitätswerten übereinstimmen und auf diese Weise eine Wellenfront am Ort der Eintrittspupille 47 des Mikroskopobjektivs 17 bestimmt, mit der die gemessenen Intensitätswerte konsistent sind.

Aus dem Vergleich der sich aus dem Iterationsverfahren ergebenden Wellenfront mit der für den Idealfall angenommenen Feldverteilung an der Eintrittspupille 47 des Mikroskopobjektivs 17 können mit Hilfe des Rechners 74 und der Stelleinrichtung 76 Steuersignale zur Ansteuerung des aktiven Spiegels 57 erzeugt werden, derart, daß die gemessene Intensitätsverteilung mit der sich aus einer idealen Feldverteilung am Ort der Eintrittspupille 47 ergebenden Intensitätsverteilung in der Brennebene übereinstimmt.

Auf diese Weise kann im Verlauf der Abtastung des Untersuchungsbereiches eine fortlaufende, selbsttätige Nachführung des Fokus 16 des Abtast-Strahlengenges auf die Oberfläche des Untersuchungsobjekts erzielt werden. Es versteht sich, daß diese Nachführung nicht für jeden Abtast-Bildpunkt durchgeführt werden kann, sondern, weil die rechnerische Verarbeitung der Punktbildfunktion eine gewisse Zeit benötigt, beispielsweise nur mit 1/100 - 1/1000 der Abtastfrequenz.

Im Rahmen des erfindungsgemäßen Geräts 10 ist weiter vorgesehen, daß in den Strahlengang der weiteren Abtast-Einrichtung 64 auch Test-Licht mit breitbandiger spektraler Verteilung einkoppelbar ist. Dadurch wird die Möglichkeit geschaffen, in bestimmten Bereichen des Beobachtungsfeldes, insbesondere in denjenigen Bereichen, die mittels der "schnellen" Bildabtast-Einrichtung 21 untersucht werden, auch die optischen Dicken der Schichtstrukturen, zu ermitteln. Die Schichtdicke dieser Strukturer wird dabei punktweise erfaßt wobei bis zu 1 000 Schichtdicken-Werte pro Sekunde gemessen werden können. Die Schichtdickenmessung erfolgt hierbei nach dem Prinzpip der sog. Weißlichtinterferenzen, wobei zur Bestimmung der Wellenlängen konstruktiver Interferenz ein Dioden-Zeilen-Spektrometer 78 vorgesehen ist, auf dessen Eintrittsspalt 79 das vom Untersuchungsobjekt zurückgeworfene Licht über einen teildurchlässigen Spiegel eingekoppelt wird.

Als Weißlichtquelle wird zweckmäßigerweise eine XB0-Lampe (Xenon-Hochdrucklampe) verwendet.

Das Gerät 10 kann dank der Verwendung des He-Cd-Lasers 22 als Lichtquelle auch zur Aufzeichnung der räumlichen Verteilung im Untersuchungsbereich vorhandener lumineszierender Moleküle benutzt werden. Hierzu genügt es, wenn zwischen dem teildurchlässigen Spiegel 48, über dem das für den Nachweis ausgenutzte Licht aus dem Abtast-Strahlengang ausgekoppelt wird, und dem Photomultiplier 19 ein Filter angeordnet wird, das für die anregende UV-Strahlung des Lasers 22 und zweckmäßigerweise auch für dessen im sichtbaren Spektralbereich emittierte Strahlung undurchlässig ist.

Die Messung der Lumineszenzstrahlung ist insbesondere interessant für die Bestimmung der Verteilung von photolackresten auf dem Wafer 11. Ein für die Lumineszmessung geeignetes Filter

82 wird zweckmäßigerweise, wie in der Fig. 1 gestrichelt angedeutet, zwischen dem teildurchlässigen Spiegel 48 und der Linse 51 angeordnet, in deren Brennebene 52 die Lochblende 53 liegt.

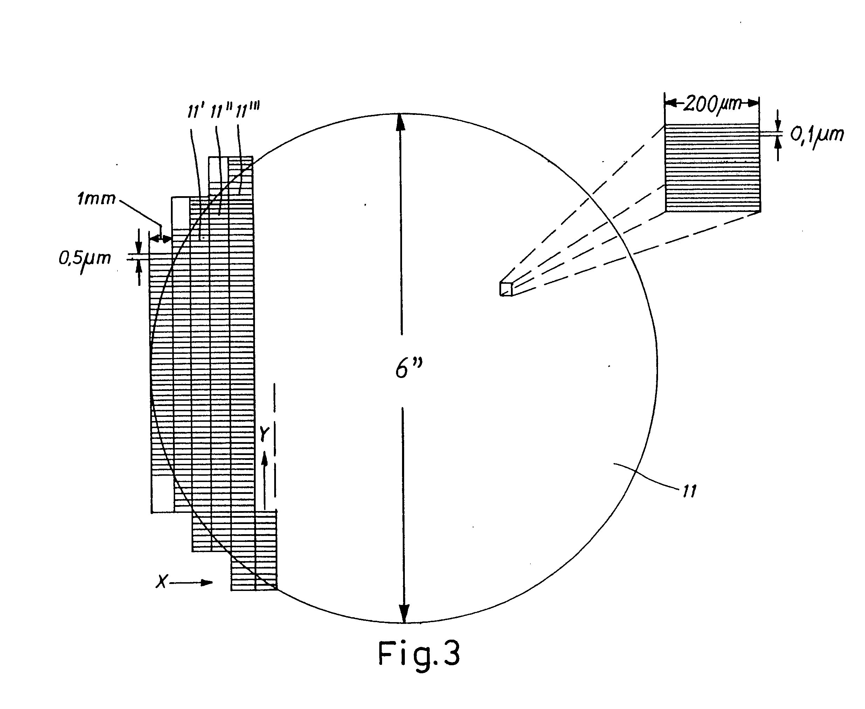

Das Abtasten des Untersuchungsfeldes kann alternativ zu der anhand der Fig. 1 geschilderten Weise auch so erfolgen, wie schematisch in der Fig. 3 dargestellt, daß das Wafer, z.B. auf einem X-, Y-Koordinatenwagen in Xund Y-Richtung verfahrbar ist und entlang einer mäanderförmigen bzw. rechteck-wellenförmigen Bahn bewegt wird. In X-Richtung gesehen, d.h. in derjenigen Richtung, in der der Polygonspiegel 32 die Strahlauslenkung vermittelt, ist die Schrittweite der Wafer-Bewegung gleich der Amplitude der Strahauslenkung gewählt. In der Y-Richtung entspricht der Bewegungshub des Wafers 11 jeweils der Ausdehnung des gewählten Untersuchungsbereiches. Auf diese Weise werden mittels der Abtasteinrichtung jeweils nebeneinander liegende, parallele streifenförmige Bereiche 11', 11'' und 11''' abgetastet. Diese Ausgestaltung des erfingungsgemäßen Geräts hat den Vorteil, daß im Rahmen der Abtasteinrichtung 31 gemäß Fig. 1 anstelle des Galvanometerspiegels 38 ein feststehender Spiegel benutzt werden kann. Außerdem ist eine schnellere Abtastung des Untersuchungsfeldes möglich, da das Wafer 11 in Y-Richtung kontinuierlich weitertransportiert werden kann. Es versteht sich, daß eine solche X-, Y-Transportvorrichtung auch in Kombination mit einem Gerät 10, wie in der Fig. 1 dargestellt, benutzt werden kann, wobei zur Abtastung eines kleinen ausgewählten Teilbereichs des Wafers 11 die Transportvorrichtung wahlweise stillgesetzt werden kann.

Ein zeitlich sehr schnell durchführbarer Vergleich eines zeilenförmigen Abtastbereiches mit einer vorgegebenen Soll-Struktur desselben kann auch mit Hilfe eines sog. Konvolvers erfolgen. Fie Funktion eines solchen Bauelementes basiert auf einer nichtlinearen Superposition von akustischen Oberflächenwellen, denen ein Amplitudenverlauf aufgeprägt werden kann, der der innerhalb einer Abtastzeile erfaßten Intensitätsverteilung des auf den Detektor der Abtasteinrichtung zurückgeworfenen Lichtes entspricht. In dem Konvolver werden in entgegengesetzter Richtung laufende akustische Wellen erzeugt, deren eine hinsichtlich ihres Amplitudenverlaufes der Soll-Struktur und deren andere dem gemessenen Intensitätsverlauf entspricht. Haben diese in entgegengesetzter Richtung sich ausbreitenden Oberflächenwellen denselben Amplitudenverlauf, so ist das Integral der aus der nichtlinearen Superposition diese akustischen Wellen entstehenden Korrelationsfunktion, — erfaßbar durch eine an einer Deckelektrode des aus piezoelektrischem Material bestehenden Konvolvers abgreifbaren Spannung — maximal. Aus dem solchermaßen gemessenen Wert des Integrals der Korrelationsfunkion der beiden Oberflächenwellen kann somit die Übereinstimmung der abgetasteten Struktur mit der Soll-Struktur festgestellt werden.

Eine solche Konvolver-Einrichtung kann nicht nur zum Zweck der Erkennung von Strukturfehlern benutzt werden, sondern auch zum Zweck einer zur vorstehend erläuterten analogen Autofokussierung des Abtaststrahlenganges auf die Oberfläche der untersuchenden Struktur.

## Patentansprüche

1. Gerät zur Wafer-Inspektion bei der Fertigung hochintegrierter Halbleiter-Bauelemente, mit einer elektronisch gesteuerten Abtast-Einrichtung, die in einem Zeilen- und Spaltenraster, der einer üblichen Fernsehnorm entspricht, mindestens für Teilbereiche der Oberfläche des Wafers eine sukzessive punktweise Abtastung der der Inspektion unterworfenen Oberflächenstrukturen des Wafers vermittelt, die mittels eines Fernsehmonitors in vergrößertem, für eine prüfende Betrachtung geeigneten Maßstab darstellbar sind, dadurch gekennzeichnet, daß als Abtast-Einrichtung ein Laser-Abtast-Mikroskop vorgesehen ist, dessen Objektiv (17) das Abtast-Lichtbündel mit einer geringen Schärfentiefe auf den Untersuchungsbereich (16) fokussiert, daß der zur Messung der Intensität des aus dem Untersuchungsbereich zurückgeworfenen Laserlichtes benutzte Nachweis-Strahlengang durch einen Teil des Beleuchtungs- bzw. Abtast-Strahlenganges des Lasers-Abtast-Mikroskops gebildet ist, aus dem mittels einer Strahlenteiler-Anordnung (48) ein Teil des in Richtung auf die Lichtquelle (22) zurückgeworfenen Lichtes auf einen photoelektrischen Detektor (19) auskoppelbar ist, daß in konfokaler Anordnung mit der die Untersuchungsebene markierenden Brennebene (16) des Mikroskop-Objektivs (17), in Ausbreitungsrichtung des zurückgeworfenen Lichtes gesehen, zwischen der Strahlenteiler-Anordnung (48) und dem Detektor (19) eine Lochblende (53) angeordnet ist, durch die nur Licht hindurchtreten kann, das aus dem Schärfentiefenbereich der durch das Mikroskop-Objektiv (17) vermittelten Abbildung bzw. Fokussierung stammt, und daß der Abtast-Strahlengang einen aktiven Spiegel (57) mit elektronisch steuerbarer Brechkraft umfaßt, durch dessen Ansteuerung die Fokussierungs-bzw. Untersuchungsebene (16), bezogen auf eine Waferfeste Bezugsebene, im Sinne einer Anhebung und/oder Absenkung veränderbar ist.

2. Gerät nach Anspruch 1, dadurch gekennzeichnet, daß der aktive Spiegel (57) im Rahmen einer zur Anpassung des Bündelquerschnittes des Abtastlichtes an die Eintrittspupille (47) des Mikroskop-Objektivs (17) vorgesehenen Strahl-Formungsoptik (27) mit telezentrischer Eingangsoptik (59, 61) und telezentrischer Ausgangsoptik (62, 63) in einer der Ebene der Eintrittspupille (47) des Mikroskop-Objektivs (17) entsprechenden Pupillenebene (47') angeordnet ist.

3. Gerät nach Anspruch 1 oder Anspruch 2, dadurch gekennzeichnet, daß ein mit der Zeilen und der Spalten-Ansteuerung der Abtastung der Unter-suchungsobjekt-Beleuchtung synchronisiert angesteuerter Bildspeicher (21) vorgesehen ist, in dem die für die einzelnen Bildpunkte einer Untersuchungsebene (16; 16'; 16'') gemessenen Intensitätswerte des zurückgeworfenen Lichtes für eine Mehrzahl von Untersuchungsebenen speicherbar sind.

4. Gerät nach einem der vorhergehenden Ansprüche, dadurch gekennzeichnet, daß ein elektro-optischer oder akusto-optischer Modulator (56) vorgesehen ist, durch dessen mit dem Einlesetakt der Detektor-Ausgangssignale in den Bildspeicher (21) synchronisierte Ansteuerung die Intensität des Abtast-Lichtstromes (23, 24', 26') veränderbar ist.

5. Gerät nach einem der vorhergehenden Ansprüche, dadurch gekennzeichnet, daß die zur Abtastung des Untersuchungsfeldes (16) vorgesehene Lichtquelle (22) mindestens zwei Emissionsbereiche deutlich verschiedener Wellenlängen $\lambda_1$ und $\lambda_2$ hat, wobei mindestens einer dieser Emissionsbereiche im UV-Spektralbereich liegt.

6. Gerät nach Anspruch 5, dadurch gekennzeichnet, daß als Lichtquelle (22) ein Helium-Cadmium-Laser vorgesehen ist, der Licht der Wellenlängen $\lambda_1$ = 325 nm und $\lambda_2$ = 440 nm emittiert.

7. Gerät nach einem der vorhergehenden Ansprüche, dadurch gekennzeichnet, daß eine zusätzliche Abtast-Einrichtung vorgesehen ist, mit der die räumliche Intensitätsverteilung Punktbildfunktion des von einem Bildpunkt des Untersuchungsfeldes (16) zurückgeworfenen Lichtes erfaßbar ist.

8. Gerät nach Anspruch 7, dadurch gekennzeichnet, daß eine Vergleichseinrichtung vorgesehen ist, die aus dem Vergleich der gemessenen Intensitätsverteilung des Punktbildes mit einer nach der Auslegung der Abbildungsoptik zu erwartenden idealen Intensitätsverteilung Stellsignale für die Ansteuerung des aktiven Spiegels (57) erzeugt, derart, daß die mit der weiteren Abast-Einrichtung (64) erfaßbare Intensitätsverteilung innerhalb vorgebbarer Toleranzen stets mit der idealen Punktbildfunktion übereinstimmt, und daß eine Auswertungseinrichtung vorgesehen ist, welche die für die Einstellung der idealen Punktbildfunktion erforderlichen Werte der Stellsignale in Einheiten des Abstandes der — eingeregelten — Untersuchungsebene von einer Wafer-festen Bezugsebene umrechnet und/oder zur Anzeige bringt.

9. Gerät nach Anspruch 8, dadurch gekennzeichnet, daß zur Bestimmung der Punktbildfunktion eine Anzahl von photoelektrischen Empfängern in Matrix-Anordnung, insbesondere eine 2 D-Diodenmatrix (73) vorgesehen ist, der ein Rechenwerk (74) nachgeschaltet ist, das aus der Verarbeitung der intensitäts-charakteristischen Ausgangssignale der Diodenmatrix (73), die zur Ansteuerung des aktiven Spiegels (57) im Sinne der Fokussierung des Abtast-Lichtes auf die Wafer-Oberfläche erzeugt.

10. Gerät nach einem der vorhergehenden Ansprüche 7 bis 9, dadurch gekennzeichnet, daß das in die zweite Abtast-Einrichtung (64) eingekoppelte Licht mittels eines teildurchlässigen Spiegels (70) vom Ausgangslichtstrom (23, 24, 26) der Laser-Lichtquelle (22) abgezweigt ist, wobei die Intensität des in die weitere Abtast-Einrichtung (64) eingekoppelten Lichtstromes (23''', 24'', 26'') nur 1/10 bis 1/5 der Intensität des Laser-Ausgangslichtstromes (23, 24, 26) beträgt.

11. Gerät nach Anspruch 10, dadurch gekennzeichnet, daß das in die weitere AbtastEinrichtung eingekoppelte Licht mittels eines zwischen der Lichtquelle (22) und dem ersten Modulator (56) angeordneten teildurchlässigen Spiegels aus dem Ausgangslichtstrom der Lichtquelle (22) auskoppelbar ist, wobei die Modulationseinrichtung der weiteren Abtast-Einrichtung (64) dem teildurchlässigen Spiegel nachgeordnet ist.

12. Gerät nach einem der vorhergehenden Ansprüche in Verbindung mit Anspruch 7, dadurch gekennzeichnet, daß in die weitere Abtast-Einrichtung (64) ein Test-Lichtstrom mit breitbandiger spektraler Verteilung des Test-Lichtes einkoppelbar ist und daß ein Spektrometer (78) vorgesehen ist, mit dem die spektrale Intensitätsverteilung des in den Ausgangszweig der weiteren Abtast-Einrichtung (64) geworfenen Lichtes erfaßbar ist.

13. Gerät nach Anspruch 12, daß das im Weißlicht-Testzweig des Gerätes (10) vorgesehene Spektrometer (78) eine wellenlängenabhängige Beugung des Testlichtes vermittelt, und daß im Rahmen dieses Spektrometers (78) als Detektoreinrichtung eine Mehrzahl von photoelektrischen Detektoren in Zeilenanordnung vorgesehen sind.

14. Gerät nach einem der vorhergehenden Ansprüche 1 bis 13, dadurch gekennzeichnet, daß im Rahmen der Bildfeld-Abtast-Einrichtung (22, 31) eine Lumineszenz-Meßeinrichtung vorgesehen ist, mit der alternativ oder gleichzeitig mit der Erfassung des zurückgeworfenen Abtast-Lichtes auch die Verteilung vom Untersuchungsobjekt durch UV-Anregung induzierten Lumineszenz-Strahlung erfaßbar und darstellbar ist.

15. Gerät nach Anspruch 14, dadurch gekennzeichnet, daß in den zum Detektor (19) der ersten Abtast-Einrichtung (31) führenden Zweig des Nachweis-Strahlenganges ein Filter (82) angeordnet ist oder in diesen Zweig des Strahlenganges einführbar ist, das die UV-Komponente des Laser-Lichtes unterdrückt, für die Lumineszenz-Strahlung jedoch durchlässig ist.

16. Gerät nach einem der vorhergehenden Ansprüche 1 bis 15, dadurch gekennzeichnet, daß eine in der Art eines Koordinaten-Wagens ausgebildete Transportvorrichtung vorgesehen ist, mittels der das Wafer (11) sowohl in der X- als auch in der Y-Abtast-Richtung verfahrbar und auf einer rechteck-wellenförmigen bzw. mäanderförmigen Bahn geführt ist, deren Bahnabschnitte in X-Richtung der X-Auslenkungsamplitude des Abtast-Lichtbündels entsprechen und deren Bahnabschnitte in Y-Richtung mindestens der in dieser Richtung gemessenen Ausdehnung des Untersuchungsbereiches entsprechen.

17. Gerät nach einem der vorhergehenden Ansprüche, dadurch gekennzeichnet, daß zum Vergleich eines zeilenförmigen Abtastbereiches mit einer vorgegebenen Soll-Struktur ein Konvolver aus piezoelektrischem Material vorgesehen ist, an dessen Oberfläche in entgegengesetzter Richtung sich ausbreitende Oberflächenwellen erzeugbar sind, deren Amplitudenverlauf einerseits der innerhalb einer Abtastzeile erfaßten Intensitätsverteilung des auf den Detektor der Abtasteinrichtung zurückgeworfenen Lichtes und andererseits einem für Übereinstimmung mit der Soll-Struktur charakteristischen Amplitudenverlauf entspricht, der sich ergäbe, wenn die Soll-Struktur abgetastet würde, und daß eine Meßeinrichtung vorgesehen ist, die den Integralwert der Korrelationsfunktion der beiden Oberflächenwellen mißt.

**Revendications**

1. Appareil d'inspection des tranches lors de la fabrication de composants semi-conducteurs à intégration poussée, comportant un dispositif d'exploration commandé électroniquement, qui détermine selon un tramage en lignes et en colonnes, correspondant à une norme vidéo usuelle, au moins pour des zones partielles de la surface de la tranche, une exploration point par point successive des structures superficielles de la tranche qui sont soumises à l'inspection, qui sont représentables au moyen d'un moniteur vidéo, à une échelle agrandie, appropriée pour une observation de contrôle, caractérisé en ce qu'un microscope à balayage laser est prévu comme dispositif d'exploration, dont l'objectif (17) focalise le faisceau d'exploration avec une profondeur de champ limitée sur la zone de recherche (16), en ce que le trajet du rayon de contrôle utilisé en vue de la mesure de l'intensité de la lumière laser revenant par réflexion de la zone de contrôle est constitué d'une partie du trajet du rayon d'éclairage ou d'exploration du microscope à balayage laser, à partir duquel, au moyen d'un dispositif diviseur de rayon (48), une partie de la lumière réfléchie en direction de la source lumineuse (22) est découplable sur un détecteur photoélectrique (19), en ce que, dans une disposition à foyer commun avec le plan focal (16) de l'objectif du microscope (17) marquant le plan de contrôle, en observant dans le sens de la propagation de la lumière réfléchie, un diaphragme troué (53) est disposé entre le dispositif diviseur de rayon (48) et le détecteur (19), au moyen duquel il ne peut entrer qu'une lumière qui provient de la plage de profondeur de champ de la représentation ou de la focalisation obtenue au moyen de l'objectif du microscope (17), et en ce que le trajet du rayon d'exploration comprend un miroir actif (57) à réfrangibilité commandable électroniquement, au moyen de la commande duquel le plan de focalisation ou de contrôle (16), par rapport à un plan de référence fixe relativement à la tranche, est modifiable au sens d'un soulèvement ou d'un abaissement.

2. Appareil selon la revendication 1, caractérisé en ce que le miroir actif (57) est disposé dans le cadre d'une optique de formation de rayon (27) prévue pour adapter la section transversale du faisceau de la lumière d'exploration à la pupille d'entrée (47) de l'objectif du microscope (17), avec une optique d'entrée (59, 61) télécentrique et une optique de sortie (62, 63) télécentrique, dans un plan de pupille (47') correspondant au plan de la pupille d'entrée (47) de l'objectif du microscope (17).

3. Appareil selon la revendication 1 ou 2, caractérisé en ce qu'il est prévu une mémoire d'image (21) commandée de manière synchronisée à la commande par ligne et par colonne du balayage de l'éclairement de l'objet à contrôler, dans laquelle les valeurs d'intensité de la lumière réfléchie, mesurées pour les points individuels d'un plan de contrôle (16; 16'; 16''), sont susceptible d'être mémorisées pour plusieurs plans de contrôle.

4. Appareil selon l'une des revendications précédentes, caractérisé en ce qu'il est prévu un modulateur électro-optique ou acoustico-optique (56), au moyen duquel l'intensité du flux lumineux de balayage (23, 24', 26') est modifiable à l'aide de la commande qui est synchronisée avec cadence de lecture des signaux de sortie du détecteur dans la mémoire d'image (21).

5. Appareil selon l'une des revendications précédentes, caractérisé en ce que la source lumineuse (22) prévue pour le balayage du champ de contrôle (16) comporte au moins deux plages d'émission de longueurs d'ondes $\lambda_1$ et $\lambda_2$ nettement différentes, au moins l'une de ces plages d'émission étant située dans la plage spectrale des UV.

6. Appareil selon la revendication 5, caractérisé en ce qu'un laser hélium-cadmium émettant de la lumière de longueurs d'ondes $\lambda_1 = 325$ nm et $\lambda_2 = 440$ nm est prévu comme source lumineuse (22).

7. Appareil selon l'une des revendications précédentes, caractérisé en ce qu'il est prévu un dispositif d'exploration supplémentaire, à l'aide duquel on peut mesurer le quotient spatial répartition de l'intensité/fonction d'image ponctuelle de la lumière réfléchie par un point image du champ de contrôle (16).

8. Appareil selon la revendication 7, caractérisé en ce qu'il est prévu un dispositif comparateur qui, à partir de la comparaison de la répartition mesurée de l'intensité de l'image ponctuelle avec une répartition idéale d'intensité que l'on peut attendre de la détermination de l'optique de représentation produit des signaux de réglage destinés à la commande du miroir actif (57), de sorte que la répartition de l'intensité qui est mesurable à l'aide du dispositif d'exploration (64) supplémentaire coïncide toujours, dans les limites de tolérances prédéterminables, avec la fonction d'image ponctuelle idéale, et en ce qu'un dispositif d'exploitation est prévu, qui converti et/ ou affiche les valeurs nécessaires au réglage de la fonction de point image idéale des signaux de réglage en unités de la distance existant entre le plan -réglé- de contrôle et un plan de référence fixe par rapport à la tranche.

9. Appareil selon la revendication 8, caractérisé en ce que pour déterminer la fonction de point image, il est prévu un certain nombre de récepteurs photoélectriques agencés en matrice, en particulier en une matrice à diodes 2 D (73), en aval de laquelle est placée un calculateur (74) qui produit la commande du miroir actif (57), à partir du traitement des signaux de sortie, caractéristiques de l'intensité, de la matrice à diode (73), au sens de la focalisation de la lumière de balayage sur la surface de la tranche.

10. Appareil selon l'une des revendications précédentes 7 à 9, caractérisé en ce que la lumière couplée dans le dispositif d'exploration (64) est dérivée du flux lumineux de sortie (23, 24, 26) de la source lumineuse laser (22) au moyen d'un miroir partiellement translucide (70), l'intensité du flux lumineux (23'', 24'', 26'') couplé dans le dispositif d'exploration (64) supplémentaire ne valant que de 1/10 à 1/5 de l'intensité du flux lumineux de sortie laser (23, 24, 26).

11. Appareil selon la revendication 10, caractérisé en ce que la lumière couplée dans le dispositif d'exploration supplémentaire est découplable du flux lumineux de sortie de la source lumineuse (22) au moyen d'un miroir partiellement translucide disposé entre la source lumineuse (22) et le premier modulateur (56), le miroir partiellement translucide étant placé en aval du dispositif de modulation du dispositif d'exploration (64) supplémentaire.

12. Appareil selon l'une des revendications précédentes, en liaison avec la revendication 7, caractérisé en ce qu'un flux lumineux d'essai à répartition spectrale à bande large de la lumière d'essai est couplable dans le dispositif d'exploration (64) supplémentaire, et en ce qu'il est prévu un spectromètre (78) à l'aide duquel est mesurable la répartition spectrale de l'intensité de la lumière émise dans la ramification de sortie du dispositif d'exploration (64) supplémentaire.

13. Appareil selon la revendication 12, caractérisé en ce que le spectromètre (78) prévu dans la ramification d'essai à lumière blanche de l'appareil (10) détermine une diffraction de la lumière d'essai qui dépend de la longueur d'onde, et en ce que, dans le cadre de ce spectromètre (78), plusieurs détecteurs photoélectriques sont prévus disposés en lignes, comme dispositif détecteur.

14. Appareil selon l'une des revendications précédentes 1 à 13, caractérisé en ce que, dans le cadre du dispositif d'exploration de champ image (22, 31), il est prévu un dispositif de mesure de la luminescence, à l'aide duquel la répartition du rayonnement de luminescence induit par l'excitation aux UV est également mesurable et représentable, alternativement ou simultanément avec la mesure de la lumière de balayage réfléchie.

15. Appareil selon la revendication 14, caractérisé en ce que, dans une branche du trajet du rayon de contrôle menant au détecteur (19) du premier dispositif d'exploration (31), il est disposé un filtre (82), ou qu'il soit susceptible d'être introduit dans cette branche du trajet du rayon, filtrant les composantes UV de la lumière laser tout en étant toutefois perméable au rayonnement de luminescence.

16. Appareil selon l'une des revendications précédentes 1 à 15, caractérisé en ce qu'il est prévu un dispositif de transport réalisé à la manière d'un chariot à coordonnées, au moyen duquel la tranche 11 est mobile aussi bien en direction des X que des Y, et qui est guidé sur une trajectoire en forme d'ondes rectangulaires ou en méandres, dont les parties de trajectoires en direction des X correspondant à l'amplitude de déplacement en X du faisceau lumineux d'exploration et dont les parties de trajectoires en direction des Y correspondent au moins à l'étendue, mesurée dans cette direction, de la plaque de contrôle.

17. Appareil selon l'une des revendications précédentes, caractérisé en ce que, pour comparer une page d'exploration en forme de ligne au moyen d'une structure de consigne prédéterminée, il est prévu un convolveur en matériau piézoélectrique, sur la surface duquel des ondes de surface se propageant en direction opposée peuvent être produites dont l'allure de l'amplitude correspond d,une, part soumise à la répartition de l'intensité, mesurée dans une ligne de balayage, de la lumière réfléchie sur le détecteur du dispositif d'exploration et d'autre part à une allure d'amplitude caractéristique pour la coïncidence avec la structure de consigne, qui résulterait si l'on explorait la structure de consigne, et en ce qu'il est prévu un dispositif de mesure qui mesure la valeur intégrale de la fonction de corrélation des deux ondes de surface.

## Claims

1. Apparatus for the inspection of wafers in the manufacture of highly integrated semi-conductor structural elements, having an electronically controlled scanning device, which in a line-scanning and column-scanning pattern, which corresponds to a usual television standard, at least for partial regions of the surface of the wafer introduces a successive point-by-point scanning of the surface structures of the wafer subjected to the inspection, which surface structures can be represented by means of a television monitor on an enlarged scale suitable for an examinatory consideration, characterized in that as scanning device a laser scanning microscope is provided, the objective (17) of which focuses the scanning light beam with a small depth of focus onto the examination region (16), in that the detection path of rays used for measuring the intensity of the laser light reflected out of the examination region is formed by a part of the illumination path of rays or scanning path of rays of the laser scanning microscope, out of which by means of a beam splitter arrangement (48) a part of the light, reflected in the direction of the light source (22), can be decoupled onto a photo-electrical detector (19), in that in confocal arrangement with the focal plane (16) of the microscope-objective (17), the focal plane marking the examination level, seen in the diffusion direction of the reflected light, between the beam splitter arrangement (48) and the detector (19) an aperture plate (53) is arranged, through which only light can pass which originates from the depth of focus region of the image or focusing introduced through the microscope-objective (17), and in that the scanning path of rays comprises an active mirror (57) with electronically controllable power of refraction, through the control of which the focusing or examination level (16), relative to a wafer-firm reference level, is variable in the sense of a raising and/or lowering.

2. Apparatus according to claim 1, characterized in that the active mirror (57) in the framework of a beam formation optical system (27), provided for the adaptation of the beam cross-section of the scanning light to the entrance pupil (47) of the microscope-objective (17), with telecentric input optical system (59, 61) and telecentric output optical system (62, 63) is arranged in a pupil level (47') corresponding to the level of the entrance pupil (47) of the microscope-objective (17).

3. Apparatus according to claim 1 or claim 2, characterized in that an image store (21) is provided, controlled in a synchronized manner with the line and the column control of the scanning of the examination object illumination, in which image store (21) the intensity values of the reflected light, the values being measured for the individual image points of an examination level (16; 16'; 16''), can be stored for a plurality of examination levels.

4. Apparatus according to one of the preceding claims, characterized in that an electro-optical or acousto-optical modulator (56) is provided, through the control of which, synchronized with the read-in time of the detector output signals in the image store (21), the intensity of the scanning light current (23, 24', 26') is variable.

5. Apparatus according to one of the preceding claims, characterized in that the light source (22) provided for the scanning of the examination field (16) has at least two emission regions of clearly different wavelengths $\lambda_1$, and $\lambda_2$, whereby at least one of these emission regions lies in the UV spectral region.

6. Apparatus according to claim 5, characterized in that as light source (22) a helium-cadmium-laser is provided which emits light of the wavelengths $\lambda_1 = 325$ nm and $\lambda_2 = 440$ nm.

7. Apparatus according to one of the preceding claims, characterized in that an additional scanning device is provided, with which the spatial intensity distribution/point image function of the light reflected from an image point of the examination field (16) is determinable.

8. Apparatus according to claim 7, characterized in that a comparison device is provided, which, from the comparison of the measured intensity distribution of the point image with an ideal intensity distribution to be expected according to the construction of the image optical system, produces adjusting signals for the control of the active mirror (57) in such a way that the intensity distribution determinable with the further scanning device (64) within tolerances which can be specified always corresponds with the ideal point image function, and in that an evaluation device is provided which converts and/or brings to notice the values of the adjusting signals, necessary for the setting of the ideal point image function, in units of the distance of the — regulated — examination level from a wafer-firm reference level.

9. Apparatus according to claim 8, characterized in that for the determination of the point image function a number of photo-electrical receivers in matrix arrangement, more particularly a 2 D-diode matrix (73) is provided, to which a calculating unit (74) is subsequently connected, which from the processing of the intensity-characteristic output signals of the diode matrix (73), which for the control of the active mirror (57) in the sense of the focusing of the scanning light on the wafer surface produces.

10. Apparatus according to one of the preceding claims 7 to 9, characterized in that the light coupled into the second scanning device (64) is branched off by means of a partially permeable mirror (70) from the output light current (23, 24, 26) of the laser light source (22), whereby the intensity of the light current (23″, 24″, 26″), coupled into the further scanning device (64), only amounts to 1/10 to 1/5 of the intensity of the laser output light current (23, 24, 26).

11. Apparatus according to claim 10, characterized in that the light coupled into the further scanning device can be decoupled out of the output light current of the light source (22) by means of a partially permeable mirror arranged between the light source (22) and the first modulator (56), whereby the modulation device of the further scanning device (64) is inserted after the partially permeable mirror.

12. Apparatus according to one of the preceding claims in connection with claim 7, characterized in that in the further scanning device (64) a test light current with wide-band spectral distribution of the test light can be coupled and in that a spectrometer (78) is provided, with which the spectral intensity distribution of the light thrown into the output branch of the further scanning device (64) is determinable.

13. Apparatus according to claim 12, in that the spectrometer (78) provided in the white light test branch of the apparatus (10) introduces a wavelength-dependent diffraction of the test light, and in that in the framework of this spectrometer (78) as detector device a plurality of photo-electrical detectors in line arrangement are provided.

14. Apparatus according to one of the preceding claims 1 to 13, characterized in that in the framework of the image field scanning device (22, 31) a luminescence measuring device is provided, with which alternatively or at the same time as the determination of the reflected scanning light also the distribution from the examination object can be determined and represented through UV stimulation induced luminescence rays.

15. Apparatus according to claim 14, characterized in that in the branch of the detection path of rays leading to the detector (19) of the first scanning device (31) a filter (82) is arranged or can be introduced into this branch of the path of rays, which suppresses the UV components of the laser light, but is permeable for the luminescence rays.

16. Apparatus according to one of the preceding claims 1 to 15, characterized in that a transport device is provided, constructed in the manner of a coordinate vehicle, by means of which the wafer (11) can be transported both in the X and in the Y scanning direction and is conducted on a rectangular wavelike or meander-shaped path, whose path sections in X direction correspond to the X deflection amplitude of the scanning light beam and whose path sections in Y direction correspond at least to the extension of the examination region measured in this direction.

17. Apparatus according to one of the preceding claims, characterized in that to compare a line-shaped scanning region with a specified desired structure a convolver consisting of piezo electrical material is provided, on the surface of which in the opposite direction diffusing surface waves can be produced, the amplitude course of which corresponds on the one hand to the intensity distribution, determined within a scanning line, of the light reflected onto the detector of the scanning device and on the other hand to an amplitude course characteristic for agreement with the desired structure, which would occur if the desired structure were scanned, and in that a measuring device is provided which dispenses with the integral value of the correlation function of the two surface waves.

Fig.1

EP 0 168 643 B1

Fig. 2

Fig.3